(19) Europäisches Patentamt
European Patent Office
Office européen des brevets

(11) **EP 4 472 006 A1**

(12) **EUROPEAN PATENT APPLICATION**

(43) Date of publication:
**04.12.2024 Bulletin 2024/49**

(51) International Patent Classification (IPC):
**H02J 3/00** (2006.01)    **G06N 3/08** (2023.01)
**H02J 13/00** (2006.01)

(21) Application number: **23176086.9**

(22) Date of filing: **30.05.2023**

(52) Cooperative Patent Classification (CPC):
**H02J 13/00002; G06N 3/08; H02J 3/0012;**
H02J 2203/20

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Siemens Aktiengesellschaft
80333 München (DE)**

(72) Inventors:
• **Duckheim, Mathias
91052 Erlangen (DE)**
• **Metzger, Michael
85570 Markt Schwaben (DE)**

(74) Representative: **Siemens Patent Attorneys
Postfach 22 16 34
80506 München (DE)**

(54) **A COMPUTER IMPLEMENTED METHOD AND APPARATUS FOR DETERMINING A CRITICALITY OF AN ELECTRICAL POWER DISTRIBUTION GRID**

(57)    A computer implemented method and apparatus for determining a criticality of an electrical power distribution grid comprising the steps of: providing (S1) a machine learning model (ML) of the power distribution grid fitted to smart meter data (smd) representing a power consumption of customers connected via a distribution transformer (DT) to conducting equipment within a substation of the power distribution grid and fitted to data representing a voltage at selected conducting equipment of the power distribution grid; using (S2) the provided machine learning model (ML) for calculating a grid impact score (GISC) representing the grid state of the power distribution grid based on power limit violations and/or based on voltage limit violations; and evaluating (S3) the calculated grid impact score (GISC) to determine the criticality of the electrical power distribution grid.

## FIG 1

EP 4 472 006 A1

**Description**

The invention relates to a computer-implemented method and apparatus for determining a criticality of a past, current or future grid state of an electrical power distribution grid.

A power distribution grid provides electrical power to customers connected via a distribution transformer to a substation of the power distribution grid. A power distribution grid may be run by a distribution system operator (DSO). Distribution system operators (DSOs) must manage the impact of distributed energy resources (DERs) such as residential PV installations, heat pumps, EV charging infrastructure. Distribution system operators further evaluate the criticality of the power distribution grid based on historical measurements and projected future states of the power distribution grid. A distribution system operator has to ensure that electric voltage changes remain within allowed bounds or ranges, e.g. a maximum voltage change of +-5 % from the nominal value in a US power distribution systems or a maximum allowed voltage change of +-10% from the nominal value in European systems. Further distribution system operators (DSOs) must ensure that the power flowing over their assets, e.g., the distribution transformers (DT), is below a given threshold e.g., the rated power of these transformers.

A conventional approach to keep voltage changes and power flows within admissible ranges is the use of a power flow model of the power distribution grid. A power-flow model is a data model of a power grid including the correct topology and line parameters that allows to accurately calculate the voltage magnitudes and angles for all phases at all nodes in the power grid given the real power consumption and reactive power consumption at all nodes. An electrical grid forms a network of interconnections between different nodes. The topology of the network can be specified by data indicating which nodes are electrically interconnected and which are not. The network topology can indicate which customers are connected to which distribution transformer (DT) and which distribution transformer (DT) is connected to which feeder and also which feeder is connected to which primary substation of the power distribution grid.

However, such a power-flow model of a power distribution grid can only be created with high digitalization and manual engineering efforts. In strategic grid design studies, a substantial part of the manual work and efforts goes into digitalization of an accurate grid model. This process is further complicated by the existence of different formats of the data from different sources and the limited accuracy of the available data.

Consequently, in most use cases no accurate power-flow model is available for planning and operation purpose. While data of a geographical information system (GIS) may provide information on location of power lines, transformers and switches of the power distribution system such data typically does not provide accurate information on the electrical connectivity, the energization of lines, nor on the correct phases to which the assets are connected to. Thus, no grid model is available that allows to accurately calculate voltages from power consumption.

Due to the absence of a power-flow model it is not possible to predict voltages in a future target period. Thus, the evaluation of a distributed energy resources grid impact score is incomplete.

For a predefined observation time period the historical voltage measurements can be directly evaluated. However, the grid impact score design based on load and generation margins (C_LGM - the load and generation margin score) also considers hypothetical power changes. The LGM score calculates what the voltage would have been if the power consumption had changed and evaluates how much more load or generation can be added to the current state of the grid until a limit is violated. An advantage of the C_LGM score is that it gives an intuitive understanding of the grid state in terms of a physical quantity, namely the load margin, and that it finds the grids proper weighting of voltage and power limit violations As an additional application for distributed energy resources (DER) a root-cause analysis can be performed where a net power profile of customers can be disaggregated into the individual contributions from different classes of DERs. The different classes of distributed energy resources can be analyzed subsequently to find out whether they are causal for observed power and voltage limit violations. This can be done via assuming a reduction of each class of DER power profiles and analyzing whether limit violations are reduced. While this is possible for power limit violations, for voltage limits, a data model that describes voltage changes in response to power changes is lacking. In summary, a model describing the relation between voltage magnitudes and power injections is lacking for grid state evaluation in terms of a grid impact score.

Accordingly, it is an objective of the present invention to provide a method and apparatus which allow to determine accurately and reliably a criticality of an electrical power distribution grid without requiring the provision of a power-flow model.

This object is achieved by a method comprising the features of claim 1.

The invention provides according to a first aspect a computer-implemented method for determining a criticality of an electrical power distribution grid comprising the steps of: providing a machine learning model (ML) of the power distribution grid fitted to smart meter data representing a power consumption of customers connected via a distribution transformer (DT) to the conducting equipment within a substation of the power distribution grid and fitted to data representing the voltages at selected conducting equipment of the power distribution grid and at the customers' connection points; using the provided machine learning model (ML) for calculating a grid impact score representing the grid state of the power distribution grid based on power limit violations and/or based on voltage limit violations; and evaluating the calculated grid impact score to determine the criticality of the electrical power distribution grid.

The method can be performed automatically and is scalable.

In a possible embodiment of the method the smart meter data is provided by a meter data management (MDM) system and comprise real power consumption profiles (P) and reactive power consumption profiles (Q) of customers connected via the distribution transformer (DT) to the conducting equipment within a substation of the power distribution grid.

In a possible embodiment of the data representing a voltage at selected conducting equipment of the power distribution grid comprise real time data provided by a SCADA system at the substation of the power distribution grid.

In a possible embodiment of the method the provided machine learning model (ML) is stored in a memory and describes voltage changes of the voltage at selected conducting equipment of the power distribution grid and at the customers connection points in response to power changes of injected electrical power consumed by customers connected via the distribution transformer (DT) to the conducting equipment within the substation of the power distribution grid.

In a possible embodiment of the method the provided network model comprises a linear model for a radial power distribution grid.

In a possible embodiment of the method the provided network model comprises a neural network model for a meshed power distribution grid.

In a possible embodiment of the method the grid impact score comprises a historic grid impact score representing the grid state of the power distribution grid for a historical past observation period and/or comprises a projected grid impact score representing an expected grid state of the power distribution grid for a future target observation period.

In a possible embodiment of the method a distribution system operator (DSO) controls controllable assets of its electrical power distribution grid depending on the determined criticality of the respective electrical power distribution grid to ensure that the voltages at selected conducting equipment of the power distribution grid and at the customers connection points remains within predefined admissible voltage bounds and/or to ensure that the electrical power flowing over its conducting equipment to the customers remains below predefined admissible power limits.

In a possible embodiment of the method asset data of assets of the power distribution system are provided by a geographical information system (GIS) containing the asset data and geographical data indicating geographical locations of the assets of the power distribution system.

The invention further provides an apparatus for determining a criticality of an electrical power distribution grid comprising

a machine learning model (ML) of the power distribution grid stored in a memory and fitted to smart meter data representing a power consumption of customers connected via a distribution transformer (DT) to a substation of the power distribution grid and fitted to data representing the voltages at the conducting equipment within a respective substation of the power distribution grid and at the customers connection points; and comprising

a processor using the provided machine learning model (ML) for calculating a grid impact score representing the grid state of the power distribution grid based on power limit violations and/or based on voltage limit violations and adapted to evaluate the calculated grid impact score to determine the criticality of the electrical power distribution grid.

In a possible embodiment of the apparatus according to the present invention the smart meter data is provided by a meter data management (MDM) system connected to smart meters of the customers and comprise real power consumption profiles (P) and reactive power consumption profiles (Q) of customers connected via the distribution transformer (DT) to the conducting equipment within a substation of the power distribution grid.

In a possible embodiment of the apparatus the data representing the voltages at selected conducting equipment of the power distribution grid comprise real time data provides by a SCADA system at the substation of the power distribution grid.

In a possible embodiment of the apparatus the learned function of the machine learning model (ML) comprises a linear model for a radial power distribution grid or comprises a neural network model for a meshed power distribution grid.

In a possible embodiment of the apparatus the grid impact score calculated by the processor comprises a historic grid impact score representing the grid state of the power distribution grid for a historical past observation period and/or comprises a projected grid impact score representing an expected grid state of the power distribution grid for a future target observation period.

In a possible embodiment of the apparatus the apparatus comprises a controller adapted to control assets of its electrical power distribution grid depending on the determined criticality of the respective electrical power distribution grid to ensure that the voltages at conducting equipment within the substation of the power distribution grid and at the customers' connection points in particular service delivery points(SDPs), remain within predefined admissible voltage bounds and/or to ensure that the electrical power flowing over its electrical power distribution grid to the customers remains below predefined admissible power limits.

In the following possible embodiments of the method and apparatus according to the present invention are described in more detail with reference to the enclosed figures.

Fig.1 shows a flowchart of a possible embodiment of a computer-implemented method according to the present invention;

Fig.2 shows a schematic diagram for illustrating the arrangement of a power distribution grid;

Fig.3 shows a schematic diagram for illustrating the calculation of a grid impact score;

Fig.4 shows a block diagram of an exemplary embodiment of an apparatus according to a further aspect of the present invention.

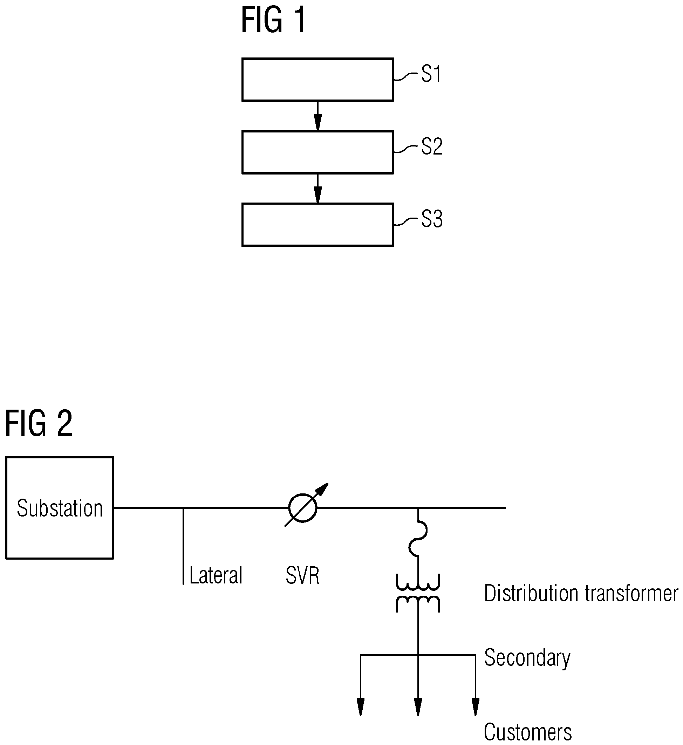

The invention provides according to a first aspect a computer-implemented method for determining a criticality for an electrical power distribution grid (such as shown in the schematic diagram of Fig 2) as illustrated in the flowchart of Fig.1. In the illustrated embodiment of Fig. 1 the method comprises three main steps.

In a first step S1 a machine learning model ML of the power distribution grid is fitted to smart meter data (smd) representing a power consumption of customers connected via a distribution transformer (DT) to the conducting equipment within a substation of the power distribution grid and fitted to data representing voltages at selected conducting equipment of the power distribution grid and customers' service delivery points (SDPs). The method avoids a manual engineering of a conventional network model by fitting from data a parametrizable map or ML model. The smart meter data (smd) can be provided by smart meters located at the premises of the customers connected to the power distribution grid. Customers connected to the local power distribution grid can comprise power consuming devices and/or power generation devices, in particular electrical power from renewable energy sources.

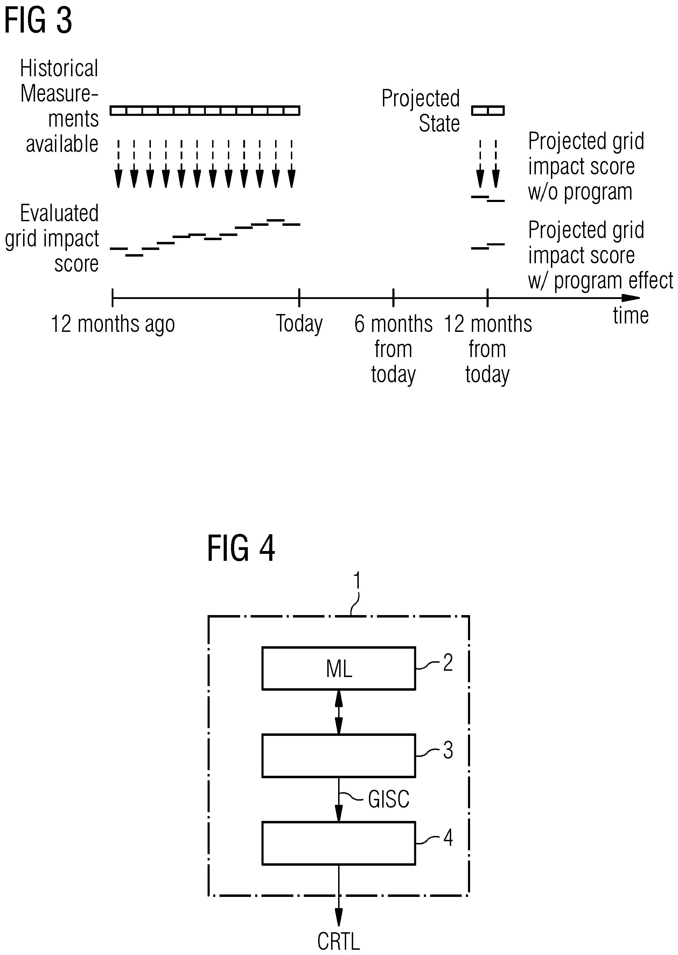

A smart meter is an electronic device that records information or data samples such as consumption data of electric energy, voltage levels, current, and power factor. Smart meters can communicate the information to the consumer for greater clarity of consumption behavior, and to electricity suppliers for system monitoring and customer billing. Smart meters can typically record energy, i.e., electrical power and voltage, near real-time, and report the recorded power data samples regularly in short intervals throughout the day. The smart meters enable in a possible embodiment a one way or two-way communication between the smart meter and the processor 2 of the apparatus 1 according to the present invention as illustrated in the block diagram of Fig.4.

The provided machine learning model ML is then used in step S2 for calculating a grid impact score GISC representing the grid state of the power distribution grid based on power limit violations and/or based on voltage limit violations,

Finally in steps S3 the calculated grid impact score GISC is processed and evaluated by a processor, FPGA or ASIC or edge device to determine the criticality or score C of the electrical power distribution grid. For example, if the calculated grid impact score GISC is higher than a predefined or adjusted threshold value an alarm message can be generated and/or countermeasures can be automatically triggered such as controlling actuators provided in the power distribution grid, in particular regulators electromechanical switches, semiconductor power switches or other controllable assets.

The method can use in a possible embodiment historical measured voltages V, and active power P, and reactive power Q measurements from the different data sources including a meter data management (MDM) system and a SCADA System.

The meter data management (MDM) system connected to smart meters can for instance provide active power data samples and reactive power data samples as well as measured voltage data samples with a predefined time resolution of e.g. 15 min.

A SCADA system can be installed at the substation of the power distribution grid and can provide voltage values at conducting equipment within the substation of the power distribution grid.

With the method according to the present invention a data-driven identification (fit) of a map from power injections P or power injections P, Q to a voltage magnitude V is performed:

$$f: (P, Q) \rightarrow V$$

Fitting is the process of constructing a curve or a mathematical function, that has the best fit to a series of data points, possibly subject to constraints. The method according to the present invention can perform in a possible implementation the following steps. Initially a model identification of the fitting function f (see different variants below) is performed and then the fitting mapping function f is used to calculate historical grid impact scores and/or to calculate projected power profiles P, Q and to evaluate voltage violations V = f(P,Q) for a projected score.

In a possible embodiment of the method the smart meter data (smd) is provided by a meter data management (MDM) system and comprise real power consumption profiles (P) and reactive power consumption profiles (Q) of customers connected via the distribution transformer (DT) to the conducting equipment within a substation of the power distribution grid.

In a possible embodiment of the data representing a voltage V at selected conduction equipment within the respective substation of the power distribution grid as illustrated in Fig. 2 comprise real time or near real time data provided by a SCADA system installed at the substation of the power distribution grid.

The provided machine learning model ML can be stored in a network model memory. The machine learning model ML describes voltage changes of the voltage at the respective substation of the power distribution grid and at the customers' service delivery points SDPs in response to power changes of injected electrical power P, Q consumed by customers connected via the distribution transformer (DT) to the conducting equipment within the substation of the power distribution grid.

A distribution transformer DT or service transformer is a transformer that provides the final voltage transformation in the electric power distribution system, stepping down the voltage used in the distribution lines to the level used by the customer. The number of customers fed by a single distribution transformer DT varies depending on the number of customers in an area. Several homes or customers may be fed from a single transformer in urban areas. Rural distribution may require one distribution transformer DT per customer, depending on the mains voltage. A large commercial or industrial complex may have multiple distribution transformers DT.

A substation is a part of the electrical generation, transmission, and distribution system. The substation is an equipment container or building comprising e.g., a transformer, that can transform voltage V from high to low, or the reverse, or perform any of several other important functions. Between the generating station and consumer, electric power may flow through several substations at different voltage levels. A substation may include transformers to change voltage levels between high transmission voltages and lower distribution voltages, or at the interconnection of two different transmission voltages.

The substation may be owned and operated by an electrical utility or may be owned by a large industrial or commercial customer. Generally, substations can remain unattended, relying on a SCADA system for remote supervision and control. A distribution substation transfers electrical power from the transmission system to the power distribution grid of an area. The input for a distribution substation is typically at least two transmission or sub-transmission lines. An input voltage may be, for example, 115 kV, or whatever is common in the area. The output is a number of feeders. Distribution voltages are typically medium voltage, between 2.4 kV and 33 kV, depending on the size of the area served and the practices of the local utility. The feeders can run along streets overhead (or underground, in some cases) and power the distribution transformers DT at or near the customer premises.

In addition to transforming voltage, distribution substations can also be provided to isolate faults in either the transmission systems or distribution systems. Distribution substations are typically the points of voltage regulation, although on long distribution circuits (of several miles/ kilometers), voltage regulation equipment may also be installed as actuators along the line.

In a possible embodiment the machine learning model ML comprises a linear model for a radial power distribution grid.

Power distribution systems are often radial. The relation between voltage magnitude and electrical power can be, to a good approximation, described by a linearized branch-flow model:

$$v - f_0 1 - R_p - X_q$$

where for a power distribution grid being radial with electrical lines having a resistance r and a reactance x and a reduced bus-branch incidence matrix A and F = A$^{-1}$ the matrices R, X are given by:

$$R - 2F diag(r) F^T$$

$$X - 2F diag(x) F^T$$

Provided that all customers are equipped with smart meters by measuring p, q, and v one can identify a structured linear model of the type X and R.

The matrices X and R are composed by the line resistances r and line reactances x with L (number of lines) parameters each.

An advantage is that this model has a substantially smaller number of parameters than two full L x L-matrices R and X while it still captures accurately the voltage sensitivities.

Different approaches for different scenarios of availability of measurements can be applied:

In a first scenario if all customers are equipped with smart meters so that smart measurement data (smd) concerning the voltage V, the power P and the reactive power Q is available at all nodes and if the measured voltage V at the substation is available as well given that all customers are equipped with smart meters by measuring p, q, and v one can identify a structured linear model of the type comprising the matrices R and X.

The matrices R and X are composed by the line resistances ri and line reactances xi of the lines with L (number of lines) parameters respectively. By using a candidate topology of the power distribution grid, i.e. the reduced bus-branch incidence matrix A a system identification approach resulting in the 2L parameters rl and Xl is practically feasible.

In a second scenario where reactive power profiles (Q-profiles) are not available a linear relation between Q = a P is assumed and the following model is fitted to the data:

$$v = f_0 1 - R' p$$

where $R' = R + X a$

In a third scenario where not all power and voltage profiles P, Q, V are available at all nodes a simplified model f can be derived from a network reduction technique such that a linear map for the remaining measured nodes is of the same form

$$V = f_0 1 - R_p - X_q$$

As an alternative a general model of the form V = f_0 1 - R p - X q (without a given structure of matrices R, X) is fitted to the available data.

Further a three-phase branch-flow model can be fitted.

In an alternative embodiment of the method the machine learning model ML comprises a artificial neural network (NN) model for a meshed power distribution grid.

In the case that the power flow equations cannot be considered as linear, e.g., when one has to deal with mesh networks, the above-described approach can be modified using feedforward neural networks instead of the affine equation:

$$v = NN(P, Q; W)$$

with neural weights W to be identified. Like the affine case a generic approach would result in too many weights, for available training data to be learned, e.g., by backpropagation algorithms.

To overcome this one can use in a possible embodiment the known topology of the electrical power distribution grid to define the topology of the neural network NN, i.e., reduce the non-zero neural weights W such that active power profiles P or reactive power profiles Q at the service delivery point SDP can only contribute the neural network outputs, that represent the voltages that can physically be affected by them. The measurement scenarios from the linear case can be analogously transferred to the neural network approach. The neural network weights W are calculated by one of the variants of the backpropagation algorithm. Different kinds of neural networks NN can be employed depending on the use case.

In a possible embodiment of the method the grid impact score GISC comprises a historic grid impact score hGISC representing the grid state of the power distribution grid for a historical past observation period as illustrated in Fig.3. The grid impact score GISC can also comprises a projected grid impact score pGISC representing an expected grid state of the power distribution grid for a future target observation period as also shown in Fig.3.

In a possible embodiment of the method a distribution system operator (DSO) operates a controller that can control in a further step controllable assets of its electrical power distribution grid depending on the determined criticality or score of the respective electrical power distribution grid to ensure that the voltages V at conducting equipment within the substation of the power distribution grid or at the customers' service delivery points (SDPs) remains within predefined admissible voltage bounds and/or to ensure that the electrical power flowing over its electrical power distribution grid to the customers remains below predefined admissible power limits.

In a possible embodiment of the method asset data of assets of the power distribution system are provided by a geographical information system (GIS) containing the asset data and geographical data indicating geographical locations of the assets of the power distribution system.

The invention further provides according to a further aspect an apparatus 1 for determining a criticality of an electrical power distribution grid as illustrated in the block diagram of Fig.4. The apparatus 1 comprises a machine learning model ML of the power distribution grid stored in a memory 2 and being fitted to available smart meter data (smd) representing a power consumption (real and or reactive) of customers connected via a distribution transformer (DT) to conducting equipment within a substation of the power distribution grid (as also illustrated in Fig.2) and fitted to data representing voltages V at conducting equipment within the respective substation of the power distribution grid or at the customers' service delivery points SDPs. The apparatus 1 further comprises a processor 3 using the provided model ML for calculating at least one grid impact score GISC representing the grid state of the power distribution grid based on a number of observed power limit violations and/or based on a number of observed voltage limit violations and adapted to evaluate the calculated grid impact score GISC to determine the criticality C of the electrical power distribution grid.

In a possible embodiment of the apparatus 1 the smart meter data (smd) is provided by a meter data management (MDM) system connected to smart meters of the customers and comprise real power consumption profiles (P) and reactive power consumption profiles (Q) of customers connected via the distribution transformer (DT) to conducting equipment within the substation of the power distribution grid. The data representing voltages for distributed energy resources in the power distribution grid comprise in a possible embodiment real time data provided by a SCADA system at the substation of the power distribution grid.

In a possible embodiment of the apparatus 1 the used machine learning network model ML is a linear model for a radial power distribution grid. In an alternative embodiment of the apparatus the used machine learning model ML comprises a neural network model NN for a meshed power distribution grid. The used network model NM can be read from a memory 2 of the apparatus 1 or can be loaded by the apparatus 1 from a database via a data network.

In a possible embodiment of the apparatus 1 the grid impact score GISC calculated by the processor 2 of the apparatus 1 comprises a historic grid impact score hGISC representing the grid state of the power distribution grid for a historical past observation period and/or comprises a projected grid impact score pGISC representing an expected grid state of the power distribution grid for a future target observation period.

In a possible embodiment the apparatus 1 further comprises a controller 4 adapted to control assets , in particular actuators, of the electrical power distribution grid depending on the determined at least one criticality score C of the respective electrical power distribution grid to ensure that the voltage V at conducting equipment within the substation of the power distribution grid remains for all electrical phases (L1,L2,L3)within predefined admissible voltage bounds and/or to ensure that the electrical power P, Q flowing over the electrical power distribution grid from or to the connected customers remains below predefined admissible power limits.

Data for power distribution systems or power distribution grids can be received from different data sources providing data to the processor 3 of the apparatus 1 illustrated in Fig.4.

These data sources can comprise a geographical information system (GIS) which contains data of different assets of the power distribution grid such as lines, transformers, etc. and their respective geographical locations.

The data sources can further comprise a customer database including data on customers, their addresses, IDs, billing data (typically implemented as an Enterprise Resource Planning (ERP) system).

Another type of data source includes a distributed energy resource (DER) registry with master data including static data of photovoltaic (PV) installations or other renewable energy resources at the premises of customers, installed power generators or power storages, installation locations and asset owners.

A further data source comprises a meter data management (MDM) system providing smart meter data (smd) generated by smart meters with net power consumption profiles P and power generation profiles from customers, voltage measurement profiles V and reactive power measurement profiles Q.

A SCADA (Supervisory control and data acquisition) system forms a further data source providing real-time measurements from the monitored system, e.g., electrical current and voltage at feeders from primary substations.

An electrical grid, in particular a power distribution grid, is formed by a network of interconnections between different nodes. The topology of the network comprises the data on which nodes are electrically interconnected and which are not. Mathematically, the network topology can be described by a bus-branch incidence matrix A (defining which lines are connected to and from which node). From the incidence matrix an adjacency matrix can be calculated. From the network topology one also knows which customers are connected to which distribution transformer DT and which distribution transformer DT is connected to which feeder and in turn which feeder is connected to which primary substation of the power distribution grid.

Distribution system operators (DSOs) of the power distribution grids must manage the impact of distributed energy resources (DERs) comprising e.g., residential PV installations, heat pumps, Electric Vehicle (EV) charging infrastructure. Distribution system operators (DSOs) evaluate the determined criticality C of their power supply grids based on historical measurements and in projected (future) states of the respective power distribution grids.

A grid impact score GISC is a KPI (key Performance Indicator) evaluating the grid states in different locations and aggregations supporting the distribution system operators (DSOs) in understanding which segments of the grid are in a critical state and which are in a safe state. These scores are based, e.g., on the number of violations for voltage and for power limits. Both a historical observation period and/or a future target period can be investigated.

The described approach taken by the method according to the present invention sidesteps the creation of a power-flow model which is expensive and which is not scalable for an automated software solution.

A grid management software can implement the method according to the present invention and can take into account future voltage violations during at least one target observation time period when evaluating projected grid states of the power distribution grid without requiring a power-flow model.

In the following details of a possible implementation of calculating a DER grid impact score GISC in step S2 of the method are described.

Relevant factors or parameters for calculating a grid impact score (per distribution transformer DT) comprise observed power violations and observed voltage violations.

For power violations a number of observed violations during an observation time period (e.g. one month) and a maximum severity of violations can be taken into account.

Defining the aggregated (active) power P of all smart meters:

$$P_{DTM,i}^{\leftharpoonup}(t) = \sum_{n \in m_{DT \to SM,i}} P_{n,t}$$

the severity (criticality) score C becomes:

$$C_i^{max-p} = max_{t \in T}(P_{DTM,i}^{\leftharpoonup}(t) - S_{DTM,i,max})$$

for a transformer DT with id i. The larger the value of the score C is the more critical is the grid state of the power distribution grid.

This approximates the power factor, cos_phi, of all customers as around 1. Typical power factors for households are 0.95 to 1. Note that the approximation cos_phi ~1 is optimistic with respect to the DT transformer limit (neglecting reactive power) .

Average severity of violations can comprise a number of time intervals with a limit violation:

$$C_i^{N-limit} = \sum_{t=1,...,N} \Theta\left[P_{DTM,i}^{\leftharpoonup}(t) - S_{DTM,i,max}\right]$$

where theta is the step function:

$$\Theta(x) = \begin{cases} 1 \, for \, x > 0 \\ 0 \, else \end{cases}$$

and the summation is performed over the observation period with t=1,...,N.

This score C counts the number of power violations over a period of N time steps, say, over one month with 96 x 31 time steps at a 15 min time resolution. The maximum value in this case is 96 x 31, i.e., a limit violation occurring in each time step.

Other metrics or factors which can be used to calculate the grid impact score GISC in step S2 can for instance comprise an average duration of power violations, a maximum duration of power violations or combined violations KPI (e.g., integral of (power - capacity)) or an observed power imbalance.

Also, hypothetical violations can be taken into account when calculating the grid impact score GISC. These hypothetical violations comprise violations assuming additional loads or assuming stricter limits.

A number of near-violations (> 80% of capacity) per observation time period (e.g.1 month) can be considered.

Parametric: number of power violations assuming additional ("probing") power generation:

$$C_i^{probe-p-gen}(\Delta_p) = \sum_t \Theta\left[P_{DTM,i}^{\leftharpoonup}(t) - \Delta_p - S_{DTM,i,max}\right]$$

Parametric: number of power violations at a given additional ("probing") load:

$$C_i^{probe-p-load}(\Delta_p) = \sum_t \Theta\left[P_{DTM,i}^{\leftharpoonup}(t) + \Delta_p - S_{DTM,i,max}\right]$$

Interpretation: Larger values of this score C indicate a more critical state of the power distribution grid. This score assumes the addition of a constant load and, hence, also at the maximum load time step. If this score is a non-zero number, say 12, at a probing value of, e.g., 5kW, it indicates that adding an extra load of 5kW causes 12 power limit violations.

Parametric: number of time steps with power violations for a given power limit S {\max}:

$$C_i^{N-p-limit}(S_{max}) = \sum_t \Theta\left[P_{DTM,i}^{\leftrightarrow}(t) - S_{max}\right]$$

Note that this parametric score comprises the number of power violations as a special case:

$$C_i^{N-limit} = C_i^{N-p-limit}(S_{DTM,i,max})$$

The load margin comprises the smallest constant load to be added until the distribution transformer power limit is reached.

If considering only power violations this score can be evaluated as the margin of the power maximum from the power limit.

Interpretation: Larger values of this score indicate a healthy state of the power distribution grid. This score can become negative indicating that the present-state load is too high. The score assumes the addition of a constant load and, hence, also at the maximum load time step. If the score is a positive number, say 5kW, it indicates that adding an extra load of 5kW is possible without causing limit violations.

When considering also voltage violations the following optimization formulation generalizes more straightforwardly:

$$H_i^{margin-p-load} = min\Delta p$$

such that:

$$C_i^{probe-p-load}(\Delta p) > 0 \; and \; \Delta p > - max_t \left|P_{DTM,i,t}^{\leftrightarrow}\right|$$

Duration of near-violations (> 80% of capacity) e.g. per month can also be taken into account when calculating the grid impact score.

Parametric: duration of power violations at given additional ("probing") power generation.

Parametric: duration of power violations at given additional ("probing") electrical load

Besides the power violations also voltage violations can be considered when calculating the grid impact score.

The number of voltage violations (+/-) per observation time period (e.g. 1 month) con influence the grid impact score.

Input: For each smart meter with id n one needs as input data the nominal voltage at the service delivery point V_{n, nom} and the upper/lower voltage limit at the service delivery point V_{n, max}, V_{n, min} and the measured voltage magnitude V_{n, t}.

Output:

The number of upper voltage limit violations at the service delivery point n is:

$$C_n^{N-p-limit,V+}(V_{n,max}) = \sum_t \Theta[V_n(t) - V_{n\,max}]$$

The number of lower voltage limit violations at the service delivery point n is:

$$C_n^{N-p-limit,V-}(V_{n,min}) = \sum_t \Theta[-V_n(t) + V_{n\,min}]$$

Further the grid impact score GISC can depend on an average severity of voltage violations (+/-), a maximum severity of voltage violations (+/-) and an average duration of voltage violations (+/-) as well as a maximum duration of voltage violations (+/-).

Also combined voltage violations KPI (e.g., integral of (voltage - limit)), an observed voltage imbalance and a number of near-voltage violations (> 80% of capacity) per observation time period (e.g. 1 month) can be considered when calculating the grid impact score in step S2.

An optimization can be performed an can be based on a hosting capacity additional flat generation (positive/-negative), a hosting capacity additional flat load (positive/negative), a hosting capacity PV (positive/negative), a hosting capacity EV (positive/negative) and on BESS required to avoid violations

Other factors can influence the calculation of the grid impact score GISC in step S2 as well. These factors include flicker, harmonic effects, Short-circuit power and power fluctuation

Different scores, parameters, factors can be combined to calculate a grid impact score GISC (per distribution transformer DT) .

A first version ((power only) - PLV) of the grid impact score (GISC) C-PLV that satisfies specific requirements counts power limit violations (PLV). It is the weighted superposition of the above building blocks, namely the number of near-violations with a lower weight and the number actual violations:

$$C_i^{PLV} = 0.1 \, x \, C_i^{N-p-limit}\left(0.9 * S_{DTM,i,max}\right) + 1.0 \, x \, C_i^{N-p-limit}\left(S_{DTM,i,max}\right)$$

Intuitively, this can be read as "10 near-limit-violations are as critical as one actual limit violation".

A further version of the grid impact score (GISC)((power and voltage) - PVLV) C-PVLV counts power limit violations (PLV)and voltage violations. It is the weighted superposition of the above building blocks, namely the number of near- violations with a lower weight and the number actual violations for, both, voltage V and power:

$$C_i^{PVLV} = C_i^{PLV} + \sum_{n \in mDT \to SM,i} \left[ 0.1 \, x \, C_n^{N-p-limit,V+}\left(0.9 * V_{n,max}\right) + 0.1 \, x \, C_n^{N-p-limit,V-} \right.$$

$$\left(1.1 * V_{n,min}\right) + 1.0 \, x \, C_n^{N-p-limit,V+}\left(V_{n,max}\right) + 1.0 \, x \, C_n^{N-p-limit,V-}\left(V_{n,min}\right)$$

Intuitively, this can be read as "10 near-limit-violations for both, power and voltage, are as critical as one actual limit violation".

This score C can only be calculated and then evaluated if voltage measurements or projections are available. Thus, for DSO with smart metering that measures voltage the historical score can be evaluated.

To additionally satisfy the requirement that the score C remains finite one can define a rescaled version of the above superposition ((power only) - PLV rescaled)):

$$C_i^{PLVr} = 0.5 \, x \, g \, \left(C_i^{N-p-limit}\left(0.9 * S_{DTM,i,max}\right) - C_i^{N-p-limit}\left(S_{DTM,i,max}\right)\right) +$$

$$g\left(C_i^{N-p-limit}\left(S_{DTM,i,max}\right)\right)$$

using an indicator function g as defined below.

Interpretation:

If there are no near-violations or violations the score C^{PLV rescaled} is 0.

If there are near-violations but no violations the score C^{PLV rescaled} is between 0.5 and 1. If there are violations the score C^{PLV rescaled } is between 1 and 3.

As a further version ((power only) - load and generation margin)) a grid health score (a score that indicates safer grid states the larger it is) the load margin and generation (LGM) score can be applied:

$$H_i^{LGM} = min\left(H_i^{margin-p-load}, H_i^{margin-p-gen}\right) / S_{DTM,i,max}$$

for a distribution transformer DT with id i.

This score can be read as the remaining possible addition of DERs (generators and load) until a limit is reached. Note that the score can also be negative, say -10%, indicating that either load or power generation has to be reduced by 10% in order to observe all limits again.

Grid impact scores GISC on the feeder level can be aggregated to feeder level by maximization. Given the scores for all distribution transformers DT with id i and a mapping, m_feeder [ri] from feeder r to all its connected distribution transformers DT the aggregated grid impact score C for feeder r is:

$$C_r^{PLV} = max_{i \in m_{F \to DT,r}} C_i^{PLV}$$

The health score H_LGM can be aggregated to feeder level by minimization:

$$H_r^{LGM} = min_{i \in m_{F \to DT,r}} H_i^{LGM}$$

To support an intuitive understanding of "no", "one"/"some", "many" violations one can define in a possible embodiment define an indicator function g with the following properties:

g(0) =0
g(1) =1
g' (1) = 1
g(x) → 2 for x → inf

The indicator function g is given as:

$$g(x) = \begin{cases} x \ for 0 <= x <= 1 \\ 1/(1 + e^{2(1-x)}) \ for \ x \ > 1 \end{cases}$$

A second option can be using a logarithmic scaling. Logarithmic scaling does only increase the score if a new order of magnitude of violations is reached, e.g. a number of violations 10 or 11 would yield a similar score, while 100 violations would increase the score further by a higher order. Such an indicator function g2 is given as:

$$g_2(x) = \begin{cases} x \ for 0 <= x <= 1 \\ \ln(x) + 1 \ for \ x \ > 1 \end{cases}$$

As can be seen from the above exemplary implementations different sub-scores can be calculated and combined to calculate in step S2 of the computer-implemented method one or more grid impact scores (GISC) representing a criticality of the state (past and/or future) of the monitored power distribution grid. The definition of sub-scores and of the combined grid impact score GISC can depend on the use case and in particular on the availability of different kinds of data. In a possible embodiment the apparatus 1 comprises a graphical user interface GUI to display the criticality of the monitored power distribution grid and the underlying grid impact scores GISCs. Further it is possible to edit and define a grid impact scores GISC by means of the user interface.

## Claims

1. A computer implemented method for determining a criticality of an electrical power distribution grid comprising the steps of:

   providing (S1) a machine learning model (ML) of the power distribution grid fitted to smart meter data (smd) representing a power consumption of customers connected via a distribution transformer (DT) to conducting equipment of a substation of the power distribution grid and fitted to data representing voltages at selected conducting equipment of the power distribution grid and at the customers' service delivery points (SDPs);
   using the provided machine learning model (ML) for calculating (S2) a grid impact score (GISC) representing the grid state of the power distribution grid based on power limit violations and/or based on voltage limit violations; and
   evaluating (S3) the calculated grid impact score (GISC) to determine the criticality of the electrical power distribution grid.

2. The method according to claim 1 wherein the smart meter data is provided by a meter data management (MDM) system and comprise active power consumption profiles (P) and reactive power consumption profiles (Q) and voltage (V) of customers connected via the distribution transformer (DT) to the conducting equipment within the substation of the power distribution grid.

3. The method according to claim 1 or 2, wherein the data representing a voltage at the conducting equipment within the respective substation of the power distribution grid comprise real time data provided by a SCADA system at the substation of the power distribution grid.

4. The method according to any of the preceding claims 1 to 3 wherein the provided machine learning model (ML) is stored in a model memory and describes voltage changes of the voltages at the selected conducting equipment of the power distribution grid and at the customers' service delivery points (SDPs) in response to power changes of injected electrical power consumed by customers connected via the distribution transformer (DT) to conducting equipment within the substation of the power distribution grid.

5. The method according to any of the preceding claims 1 to 4 wherein the provided machine learning model (ML) comprises a linear model for a radial power distribution grid.

6. The method according to any of the preceding claims 1 to 4 wherein the provided machine learning model (ML) comprises a neural network model (NN) for a meshed power distribution grid.

7. The method according to any of the preceding claims 1 to 6 wherein the grid impact score comprises a historic grid impact score (hGISC) representing the grid state of the power distribution grid for a historical past observation period and/or comprises a projected grid impact score (pGISC) representing an expected grid state of the power distribution grid for a future target observation period.

8. The method according to any of the preceding claims 1 to 7 wherein a distribution system operator (DSO) controls controllable assets of its electrical power distribution grid depending on the determined criticality of the respective electrical power distribution grid to ensure that the voltage at conducting equipment within the substation of the power distribution grid remains within predefined admissible voltage bounds and/or to ensure that the electrical power flowing over its electrical power distribution grid to the customers remains below predefined admissible power limits.

9. The method according to claim 8 wherein asset data of assets of the power distribution grid are provided by a geographical information system (GIS) containing the asset data and geographical data indicating geographical locations of the assets of the power distribution grid.

10. An apparatus (1) for determining a criticality of an electrical power distribution grid comprising:

   a machine learning model (ML) of the power distribution grid stored in a memory (2) and fitted to smart meter data (smd) representing a power consumption of customers connected via a distribution transformer (DT) to the conducting equipment of a substation of the power distribution grid and fitted to data representing voltages at selected conducting equipment of the power distribution grid and at the customers' service delivery points (SDPs) ; and
   a processor (2) using the provided machine learning model (ML)for calculating at least one grid impact score (GISC) representing the grid state of the power distribution grid based on power limit violations and/or based on voltage limit violations and adapted to evaluate the calculated grid impact score (GISC) to determine the criticality of the electrical power distribution grid.

11. The apparatus according to claim 10 wherein the smart meter data (smd) is provided by a meter data management (MDM) system connected to smart meters of the customers and comprise real power consumption profiles (P) and reactive power consumption profiles (Q) and voltage (V) of customers connected via the distribution transformer (DT) to conducting equipment within the substation of the power distribution grid.

12. The apparatus according to claim 10 or 11 wherein the data representing a voltage at conducting equipment within the respective substation of the power distribution grid comprise real time data provided by a SCADA system at the substation of the power distribution grid.

13. The apparatus according to any of the preceding claims 10 to 12 wherein the machine learning model (ML) comprises a linear model for a radial power distribution grid or a neural network model for a meshed power distribution grid.

14. The apparatus according to any of the preceding claims 10 to 13 wherein the grid impact score (GISC) calculated by the processor (2) comprises a historic grid impact score (hGISC) representing the grid state of the power distribution grid for a historical past observation period and/or comprises a projected grid impact score (pGISC) representing an expected grid state of the power distribution grid for a future target observation period.

15. The apparatus according to any of the preceding claims 10 to 14 comprising a controller (4) adapted to control assets of its electrical power distribution grid depending on the determined criticality of the respective electrical power distribution grid to ensure that the voltage at conducting equipment within the substation of the power distribution grid remains within predefined admissible voltage bounds and/or to ensure that the electrical power flowing over its electrical power distribution grid to the customers remains below predefined admissible power limits.

# FIG 1

```
┌──────────────────────┐
│                      │──S1
└──────────────────────┘
          │
          ▼
┌──────────────────────┐
│                      │──S2
└──────────────────────┘
          │
          ▼
┌──────────────────────┐
│                      │──S3
└──────────────────────┘
```

# FIG 2

┌──────────────┐
│              │
│  Substation  │
│              │
└──────────────┘

Lateral          SVR

Distribution transformer

Secondary

Customers

# FIG 3

Historical
Measure-
ments
available

Projected
State

Projected grid
impact score
w/o program

Evaluated
grid impact
score

Projected grid
impact score
w/ program effect

12 months ago         Today    6 months   12 months       time
                                       from      from
                                      today     today

# FIG 4

1

ML    2

3

GISC

4

CRTL

Europäisches
Patentamt

European
Patent Office

Office européen
des brevets

# EUROPEAN SEARCH REPORT

**Application Number**

EP 23 17 6086

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 336 995 B1 (SIEMENS AG [DE]) 7 July 2021 (2021-07-07) * paragraphs [0013] - [0062] * ----- | 1-15 | INV. H02J3/00 G06N3/08 H02J13/00 |
| A | EP 4 106 131 A1 (SIEMENS AG [DE]) 21 December 2022 (2022-12-21) * paragraphs [0026] - [0045] * ----- | 1-15 | |
| A | US 2023/018146 A1 (HENSELMEYER SYLWIA [DE]) 19 January 2023 (2023-01-19) * paragraphs [0017] - [0025] * ----- | 1-15 | |

**TECHNICAL FIELDS
SEARCHED      (IPC)**

H02J
G06N

The present search report has been drawn up for all claims

| Place of search | Date of completion of the search | Examiner |
|---|---|---|
| Munich | 18 January 2024 | Berger, Josef |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
..................................................................................................
& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

**EP 23 17 6086**

This annex lists the patent family members relating to the patent documents cited in the above-mentioned European search report.
The members are as contained in the European Patent Office EDP file on
The European Patent Office is in no way liable for these particulars which are merely given for the purpose of information.

**18-01-2024**

| Patent document cited in search report | | Publication date | Patent family member(s) | | Publication date |
|---|---|---|---|---|---|
| EP 3336995 | B1 | 07-07-2021 | EP | 3336995 A1 | 20-06-2018 |
| | | | WO | 2018114166 A1 | 28-06-2018 |
| EP 4106131 | A1 | 21-12-2022 | EP | 4106131 A1 | 21-12-2022 |
| | | | WO | 2022263309 A1 | 22-12-2022 |
| US 2023018146 | A1 | 19-01-2023 | EP | 4120508 A1 | 18-01-2023 |
| | | | US | 2023018146 A1 | 19-01-2023 |

EPO FORM P0459

For more details about this annex : see Official Journal of the European Patent Office, No. 12/82